Europäisches Patentamt

European Patent Office

Office européen des brevets

(19)

(11) Veröffentlichungsnummer: **0 223 154**
**B1**

(12) **EUROPÄISCHE PATENTSCHRIFT**

(45) Veröffentlichungstag der Patentschrift:
18.07.90

(51) Int. Cl.⁵: **G03F 7/26**

(21) Anmeldenummer: 86115359.1

(22) Anmeldetag: 06.11.86

(54) Entschichtungsvorrichtung.

(30) Priorität: 15.11.85 DE 3540588

(43) Veröffentlichungstag der Anmeldung:
27.05.87 Patentblatt 87/22

(45) Bekanntmachung des Hinweises auf die Patenterteilung:
18.07.90 Patentblatt 90/29

(84) Benannte Vertragsstaaten:
DE FR GB

(56) Entgegenhaltungen:
EP-A- 0 114 402
US-A- 4 068 251
US-A- 4 081 577
US-A- 4 334 755

PATENTS ABSTRACTS OF JAPAN, Band 6,
Nr. 145 (P-132)[1023], 4. August 1982; &
JP-A-57 64 740 (NIPPON DENSHIN DENWA
KOSHA) 20-04-1982

(73) Patentinhaber: HOECHST AKTIENGESELLSCHAFT,
Postfach 80 03 20, D-6230 Frankfurt am Main 80(DE)

(72) Erfinder: Schön, Klaus-Peter, Rathenauplatz 14,
D-6200 Wiesbaden(DE)

ACTORUM AG

**Beschreibung**

Die Erfindung betrifft eine Entschichtungsvorrichtung für mit Flüssigtoner entwickelte, vorbeschichtete Druckplatten, mit Transport- und Abquetschwalzenpaaren, zwischen denen die Druckplatten hindurchlaufen und mit einer Sprüheinrichtung zum Aufsprühen von Entschichterflüssigkeit auf die entwickelte Oberfläche der einzelnen Druckplatten.

Es sind Druckplatten-Verarbeitungsanlagen in Kompaktbauweise der Firma KALLE Niederlassung der Hoechst AG bekannt, mit denen in einem Durchlauf Druckplatten entschichtet bzw. entwickelt, gespült, fixiert/gummiert und getrocknet werden. In einem Entschichtungsgerät dieser Druckplatten-Verarbeitungsanlagen werden die Entschichtungschemikalien und das Spülwasser durch Umpumpanlagen während des Plattendurchlaufes in ständiger Zirkulation gehalten. Wegen der geschlossenen Kreisläufe für die Entschichterflüssigkeit und das Spülwasser sind feste Anschlüsse an Wasserleitung und Abfluß nicht erforderlich, so daß dieses bekannte Entschichtungsgerät an jedem beliebigen Platz aufgestellt werden kann. Andere dieser bekannten Druckplatten-Verarbeitungsanlagen entwickeln, spülen, fixieren/gummieren und trocknen die Druckplatten in einem Durchlauf. Diese Geräte sind beispielsweise mit einer automatischen Nachdosierung für das Entwicklerkonzentrat zur Stabilisierung des Entwicklers ausgerüstet, der in einem geschlossenen Kreislauf innerhalb des Gerätes umläuft. Die Kühlung des Entwicklers erfolgt durch eine Wasserdurchlaufkühlung, die thermostatisch überwacht ist. Die Entwicklertemperatur wird über eine thermostatisch überwachte Entwicklerheizung geregelt.

Die Anpassung der Plattenverarbeitung in den Druckplatten-Verarbeitungsanlagen an die jeweiligen Erfordernisse erfolgt durch eine unabhängige Geschwindigkeitseinstellung für den Plattendurchlauf und für die Ausreibeelemente, wie beispielsweise Bürsten- oder Plüschwalzen.

Den bekannten Druckplatten-Verarbeitungsanlagen ist gemeinsam, daß mit einer vorgegebenen Menge an Entschichterflüssigkeit eine begrenzte Plattenanzahl entschichtet bzw. entwickelt wird. Die Anzahl der Druckplatten ist durch Sättigung der Entschichterlösung mit Schichtresten begrenzt. Mit zunehmender Viskositätserhöhung der Entschichterlösung muß die Durchlaufgeschwindigkeit der Druckplatten verringert werden, um eine zufriedenstellende Entschichtung bzw. Entwicklung zu erreichen. Dabei spielt auch der Aspekt eine Rolle, daß mit steigender Temperatur die Entschichtungsgeschwindigkeit zunimmt, jedoch einer Temperaturerhöhung Grenzen gesetzt sind, da eine relativ große Flüssigkeitsmenge aufgeheizt werden muß, was eine bestimmte Zeit erfordert und darüber hinaus auch die Gefahr von Verbrühungen durch unsachgemäße Handhabung der Druckplatten infolge der höheren Temperaturen der Entschichterflüssigkeit zunimmt. Wegen der geschlossenen Entschichterflüssigkeits-Kreisläufe in den bekannten Geräten können Druckplatten, die unterschiedliche Entschichter- bzw. Entwicklerflüssigkeiten zum Entschichten bzw. Entwickeln erfordern, erst jeweils nach entsprechenden Umrüstungsarbeiten verarbeitet werden.

Aufgabe der Erfindung ist es, eine Entschichtungsvorrichtung der eingangs beschriebenen Art so zu verbessern, daß eine gleichmäßige Qualität der Entschichterflüssigkeit für jede Druckplatte, ohne Auflösungsverluste bei gleichbleibenden Durchlaufgeschwindigkeiten der Druckplatten im Vergleich zu bekannten Geräten, gewährleistet ist und daß Druckplatten mit unterschiedlichen lichtempfindlichen Beschichtungen ohne Umrüsten der Vorrichtung verarbeitet werden können.

Diese Aufgabe wird erfindungsgemäß dadurch gelöst, daß mehrere Behälter mit unterschiedlichen Entschichterflüssigkeiten unter Druck gefüllt und jeder Behälter über ein Ventil mit zumindest einer Breitstrahldüse in einem Sprühbereich verbunden sind, daß ein erster Sensor die Öffnungszeiten der Ventile entsprechend dem Format der durchlaufenden Druckplatte steuert und daß dem Sprühbereich eine Heizzone nachgeschaltet ist, in der der Entschichterflüssigkeitsfilm mit der Druckplatte erwärmt wird.

In Ausgestaltung der Erfindung ist unterhalb des Sprühbereichs eine Wanne zum Auffangen der seitlich über die Druckplatte hinaus gesprühten Entschichterflüssigkeit angeordnet, die in einen an die Wanne angeschlossenen Auffangbehälter abgeleitet wird.

In zweckmäßiger Ausgestaltung ist das Mehrwegventil mit einem Wasseranschluß verbunden, der Wasser über das Mehrwegventil an die Breitstrahldüse zum Spülen der Düsenöffnungen liefert.

Die Weiterbildung der Erfindung ergibt sich aus den Merkmalen der übrigen Patentansprüche 4 bis 18.

Mit der Erfindung werden die Vorteile erzielt, daß eine mit Flüssigtoner entwickelte Druckplatte, wie beispielsweise Elfasol®-Druckplatte auch nach dem Entschichten die ursprüngliche Qualität des Tonerbildes aufrechterhält, die Ergebnisse mit großer Genauigkeit und entsprechender Qualität reproduzierbar sind, da jede Druckplatte mit einer definierten Menge jeweils frischer Entschichterflüssigkeit behandelt wird. Da die Entschichterflüssigkeit als dünner Film gleichmäßiger Dicke auf die Oberfläche der Druckplatte aufgesprüht wird, kann sie auch innerhalb kurzer Zeit auf erhöhte Temperatur gebracht werden, wodurch die Entschichtungsgeschwindigkeit, wie voranstehend beschrieben wurde, erhöht wird. Es ist somit nicht notwendig, wie bei bekannten Entschichtungsgeräten, den gesamten Vorrat an Entschichterlösung auf die erhöhte Temperatur zu bringen, was offensichtlich länger dauert. In Abhängigkeit von dem jeweiligen Typ von Druckplatte sind eine Einwirkzone von beispielsweise 50 cm für die erhöhte Temperatur der Entschichterflüssigkeit und Vorschubgeschwindigkeiten bis zu 3 m/min möglich. Dabei benötigen Positivplatten und elektrofotografische Druckplatten, wie z.B. Elfasol®-Druckplatten, eine geringere Einwirkzeit der Entschichterflüssigkeit als Negativplatten.

Die Erfindung wird im folgenden anhand der Zeichnungen näher beschrieben. Es zeigen:

Fig. 1 eine schematische Schnittdarstellung einer ersten Ausführungsform einer Entschichtungsvorrichtung nach der Erfindung,

Fig. 2 eine schematische Darstellung einer gegenüber Fig. 1 geringfügig abgewandelten Ausführungsform der Entschichtungsvorrichtung, und

Fig. 3 eine weitere Ausführungsform der Entschichtungsvorrichtung in schematischer Schnittansicht.

Bevor die Entschichtungsvorrichtung im einzelnen näher erläutert wird, werden einige Aspekte der Entschichtung bzw. der Entwicklung von Druckplatten erörtert.

Flüssig betonerte elektrofotografische Druckplatten zeigen im allgemeinen eine höhere Auflösung als mit Trockentoner entwickelte Platten. Das Tonerbild bzw. die Tonermaske auf der Oberfläche der Druckplatte ist beständig gegen wäßrig-alkalische Lösungen, die die Grundlage der Entschichterflüssigkeiten bilden. Tonerschichten können im allgemeinen leicht entschichtet werden, jedoch besteht in Abhängigkeit vom Benutzungsgrad der Entschichterflüssigkeit die Gefahr des Über oder Unterentschichtens des Tonerbildes, wobei die Bildqualität nicht erhalten bleibt. Qualitativ einwandfreie Entschichtung ist nur in einem engen Bereich von Verfahrensparametern möglich. Eine gewisse Überentschichtung ist im allgemeinen erwünscht, um die Druckzunahme bei hoher Druckauflage der Druckplatte vorweg zu kompensieren, eine Unterentschichtung soll nach Möglichkeit vermieden werden.

Um die Qualität des Tonerbildes einer flüssigbetonerten Druckplatte, wie beispielsweise einer Elfasol®-Platte zu erhalten bzw. eine geringfügige Überentschichtung zu erreichen, unabhängig von der Anzahl der entschichteten Druckplatten, ist eine Entschichtung mit definierter Entschichterflüssigkeitsmenge in Gestalt eines dünnen Films und die einmalige Verwendung der Entschichterlösung anzustreben.

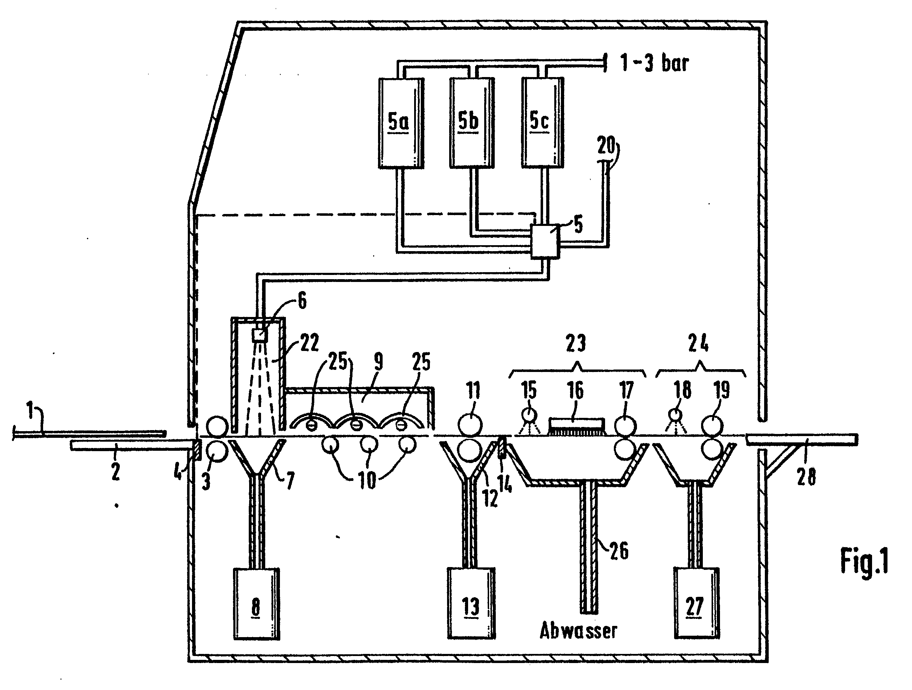

Eine schematische Darstellung des Aufbaus einer Entschichtungsvorrichtung 21 ist in Fig. 1 gezeigt. Eine zu entschichtende Druckplatte 1 wird über einen Einlauftisch 2 in den Walzenspalt eines Transportwalzenpaars 3 eingeschoben. Vor Erreichen des Walzenspaltes betätigt die Vorderkante der Druckplatte 1 einen ersten Sensor 4, der an der Hinterkante des Einlauftisches 2 angeordnet ist. Sobald der erste Sensor 4 die Vorderkante der einlaufenden Druckplatte 1 erfaßt, liefert er ein Signal an ein Mehrwegventil 5, beispielsweise ein Magnetmehrwegventil, das mit einer gewissen zeitlichen Verzögerung eingeschaltet wird. Mit dem Mehrwegventil 5 sind mehrere Behälter 5a, 5b, 5c verbunden, die mit unterschiedlichen Entschichterflüssigkeiten für verschiedene Typen von Druckplatten 1 gefüllt sind. Die Entschichterflüssigkeit in den einzelnen Behältern 5a, 5b, 5c steht unter einem Druck zwischen 1 bis 3 bar. Die Ausgangsseite des Mehrwegventils 5 ist zumindest mit einer Breitstrahldüse 6 verbunden, die sich in einem Sprühbereich 22 befindet. Die Öffnungs- und Schließzeiten des Mehrwegventils 5 werden entsprechend dem Format der durchlaufenden Druckplatte 1 gesteuert, d.h. entsprechend der jeweiligen Länge der Druckplatte 1 in Durchlaufrichtung. Wenn die Vorderkante der Druckplatte 1 über den ersten Sensor 4 das Mehrwegventil 5 öffnet, besprüht die Breitstrahldüse 6 innerhalb des Sprühbereichs 22 die Oberfläche der durchlaufenden Druckplatte 1. Es können zwei bis sechs Breitstrahldüsen 6 quer zur Durchlaufrichtung der Druckplatte 1 sich über die Breite der Druckplatte erstrecken. Die Anzahl der Breitstrahldüsen 6 hängt von der Verarbeitungsbreite der Druckplatten 1 ab. Die Zufuhr der Entschichterflüssigkeit bzw. -lösung zu den Breitstrahldüsen 6 wird durch das Mehrwegventil 5 gesteuert, wobei zwischen den Behältern 5a bis 5c und dem Mehrwegventil 5 bzw. zwischen diesem und der oder den Breitstrahldüsen 6 nicht dargestellte Filter geschaltet sind, die Verunreinigungen in der Entschichterlösung herausfiltern.

Sobald die Hinterkante der durchlaufenden Druckplatte 1 den ersten Sensor 4 passiert, schaltet dieser das Mehrwegventil 5 mit zeitlicher Verzögerung aus. Das Mehrwegventil 5 ist mit einem Wasseranschluß 20 verbunden, der nach dem Abschalten der Zufuhr von Entschichterlösung zu dem Mehrwegventil 5 Wasser über das Mehrwegventil 5 an die Breitstrahldüse 6 liefert, um deren Düsenöffnungen zu spülen und somit zu verhindern, daß diese verkleben. Unterhalb des Sprühbereichs 22 befindet sich eine Wanne 7 zum Auffangen der seitlich über die Druckplatte 1 hinaus gesprühten Entschichterlösung, die aus der Wanne in einen Auffangbehälter 8 abgeleitet wird, der in Verbindung mit der Wanne 7 steht. An den Sprühbereich 22 schließt eine Heizzone 9 an, in der die Druckplatte 1 und der darauf befindliche Film aus Entschichterflüssigkeit bzw. -lösung auf eine vorgewählte Temperatur im Bereich von 25° bis 55 °C erwärmt werden. In der Heizzone 9 können fünf bis zwölf Strahler mit Reflektoren zum Erzielen der gewünschten Temperatur vorhanden sein. Die Anzahl der Strahler richtet sich nach der Länge der gewünschten Heizzone, d.h. mit anderen Worten nach der Länge der Einwirkzone der erwärmten Entschichterflüssigkeit auf die Oberfläche der Druckplatte 1. In Fig. 1 sind drei Strahler 25 dargestellt. Die Temperaturregelung erfolgt über ein sich frei zwischen den Strahlern 25 und der Druckplatte 1 befindliches, nicht gezeigtes Thermoelement. Im allgemeinen dauert es etwa zehn Minuten, bis die Strahler 25 der Heizzone 9 soweit aufgeheizt sind, daß sie in einen stabilen Betriebszustand übergehen. Die Energieaufnahme beträgt dann beispielsweise 1,2 kW.

Für den Transport der Druckplatte 1 innerhalb der Heizzone 9 sind einige Reihen von Walzen 10, beispielsweise Stachelwalzen, unterhalb der Transportebene der Druckplatte 1 angeordnet, die den Weitertransport der Druckplatte 1 bewerkstelligen, ohne daß diese von oben gefaßt werden muß.

Hinter der Heizzone 9 ist in Durchlaufrichtung der Druckplatte 1 ein Abquetschwalzenpaar 11 angeordnet, das die Oberfläche der Druckplatte 1 von abgelöster Schicht und aufschwimmender Entschichterflüssigkeit reinigt. Unter dem Abquetschwalzenpaar 11 ist eine Auffangwanne 12 angeordnet, welche diese Rückstände auffängt und in einen angeschlossenen Behälter 13 leitet.

Der Abstand zwischen dem Transportwalzenpaar 3 und dem Abquetschwalzenpaar 11 liegt beispielsweise in der Größenordnung von 660 mm. Die reine Einwirkzone der erwärmten Entschichterlösung innerhalb der Heizzone 9 beträgt dann etwa 500 mm. Die Stachelwalzen 10 in der Heizzone 9 übernehmen den Transport von Druckplatten 1, die kürzer als 660 mm sind, sobald diese das Transportwalzenpaar 3 passiert haben. Durch die Stachelwalzen 10 können Kratzer auf der Rückseite der Druckplatte 1 entstehen. Falls diese nicht erwünscht sind, muß der Abstand zwischen dem Transportwalzenpaar 3 und dem Abquetschwalzenpaar 11 auf etwa 410 mm verkürzt werden, so daß auch die kürzeste, im Zeitungsdruck benutzte Druckplatte, von den beiden Walzenpaaren zwangstransportiert werden kann.

Dem Abquetschwalzenpaar 11 ist ein zweiter Sensor 14 nachgeschaltet, der beim Erfassen der Vorderkante der durchlaufenden Druckplatte 1 eine Reinigungsstation 23 und eine Gummierstation 24 in Betrieb setzt, die der Heizzone 9 nachgeschaltet sind. Die Reinigungsstation 23 umfaßt eine Frischwasserspülung 15, eine Reinigungsbürste 16 und ein Quetschwalzenpaar 17 zum Reinigen, Neutralisieren und Abquetschen des aufgesprühten Reinigungswassers von der Druckplattenoberfläche. Die Reinigungsstation 23 ist an eine Abwasserleitung 26 angeschlossen.

In der Gummierstation 24 ist eine Sprühdüse 18 vorhanden, welche die Gummierung auf die Druckplattenoberfläche aufsprüht. Nachgeschaltet ist ein Walzenpaar 19, das von der Druckplattenoberfläche die überschüssige Gummierung abquetscht, die in einen Auffangbehälter 27 geleitet wird.

Die Hinterkante der Druckplatte 1 setzt über den zweiten Sensor 14 mit zeitlicher Verzögerung die Entschichtungsvorrichtung 21 still, so daß die Druckplatte 1 noch auf einen Auslauftisch 28 ausgegeben werden kann.

Vor dem Ausschalten der Vorrichtung erfolgt über den Wasseranschluß 20 und das Mehrwegventil 5, wie schon zuvor erwähnt wurde, eine Spülung der Breitstrahldüsen 6 mit Wasser, um ein Verkleben der Öffnungen dieser Breitstrahldüsen 6 zu verhindern.

Die Breitstrahldüsen 6 sind Sprühdüsen, die einen vorgegebenen Sprühwinkel von beispielsweise 90° und eine dadurch vorgegebene Sprühbreite haben. Diese Düsen liefern einen fächerförmig aufgeweiteten Flachstrahl. Der Sprühdruck dieser Breitstrahldüsen läßt sich variieren, so daß die aufgesprühte Menge an Entschichterflüssigkeit entsprechend den Anforderungen für eine optimale Entschichtung bei vorgegebener Durchlaufgeschwindigkeit der Druckplatten und festgelegter Einwirkzone innerhalb der Heizzone wählbar ist.

Entsprechend dem jeweiligen Druckplattentyp wird jeweils nur derjenige von den Behältern 5a, 5b, 5c ausgewählt und mit dem Mehrwegventil 5 verbunden, der die auf den Druckplattentyp abgestimmte Entschichterflüssigkeit enthält.

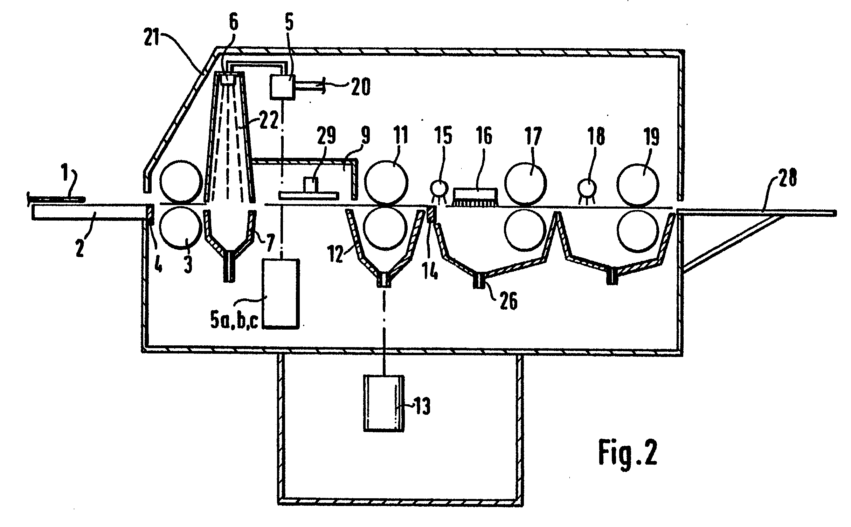

Fig. 2 zeigt eine gegenüber Fig. 1 geringfügig abgewandelte Ausführungsform der Entschichtungsvorrichtung 21. Diese Ausführungsform ist gegenüber der Ausführungsform nach Fig. 1 kompakt gebaut und enthält im wesentlichen die gleichen Bauteile wie Fig. 1, mit der Ausnahme, daß in der Heizzone 9 keine Stachelwalzen 10 vorhanden sind. Die zu entschichtende Druckplatte 1 wird über den Einlauftisch 2 in das Transportwalzenpaar 3 geschoben. Ein erster Sensor 4, der innerhalb der Gehäusewand der Entschichtungsvorrichtung 21 angeordnet ist, erfaßt die Vorder- und die Hinterkante der durchlaufenden Druckplatte 1. Die Entschichtungsvorrichtung 21 wird zu dem Zeitpunkt eingeschaltet, zu dem der erste Sensor 4 die Vorderkante der Druckplatte 1 erkennt. Aus einem der Behälter 5a, 5b, 5c, die beispielsweise hintereinander quer zur Durchlaufrichtung der Druckplatte 1 angeordnet sind, wird Entschichterlösung bzw. -flüssigkeit über das Mehrwegventil 5 und über ein nicht gezeigtes Filter der oder den Breitstrahldüsen 6 im Sprühbereich 22 zugeführt. Während des vollständigen Plattendurchlaufs sind die Breitstrahldüsen 6 eingeschaltet. Nach dem Verlassen des Sprühbereichs 22 läuft die Druckplatte 1 in die Heizzone 9 ein, in der eine Heizung 29 für die gewählte Temperatur sorgt. Unterhalb der Durchlaufebene der Druckplatte 1 sind, wie schon erwähnt, keine Stachelwalzen angeordnet, da der Abstand zwischen dem Transportwalzenpaar 3 und dem Abquetschwalzenpaar 11 am Ende der Heizzone 9 so gewählt ist, daß auch die kürzeste, noch im Zeitungsdruck verwendete Druckplatte in geführter Weise durch die beiden Walzenpaare durch die Heizzone 9 hindurchtransportiert werden kann.

Die weitgehend abgelöste Entwicklerschicht wird zusammen mit der restlichen Entschichterlösung von der Oberfläche der Druckplatte 1 durch das Abquetschwalzenpaar 11 abgequetscht. Die Flüssigkeit wird in der Auffangwanne 12 aufgefangen und in den darunter befindlichen Behälter 13 geleitet. Die nachfolgende Wässerung der Druckplattenoberfläche durch das von der Frischwasserspülung 15 aufgesprühte Frischwasser sowie das Bürsten der Druckplattenoberfläche durch die Reinigungsbürste 16 reinigt die Druckplatte 1 von Schichtresten, die durch das Quetschwalzenpaar 17 abgequetscht und über die Abwasserleitung 26 abfließen. Die Gummierung wird über die Sprühdüse 18 angetragen und ihr Überschuß durch das Walzenpaar 19 abgequetscht. Die fertig entschichtete Druckplatte 1 wird auf den Auslauftisch 28 ausgetragen.

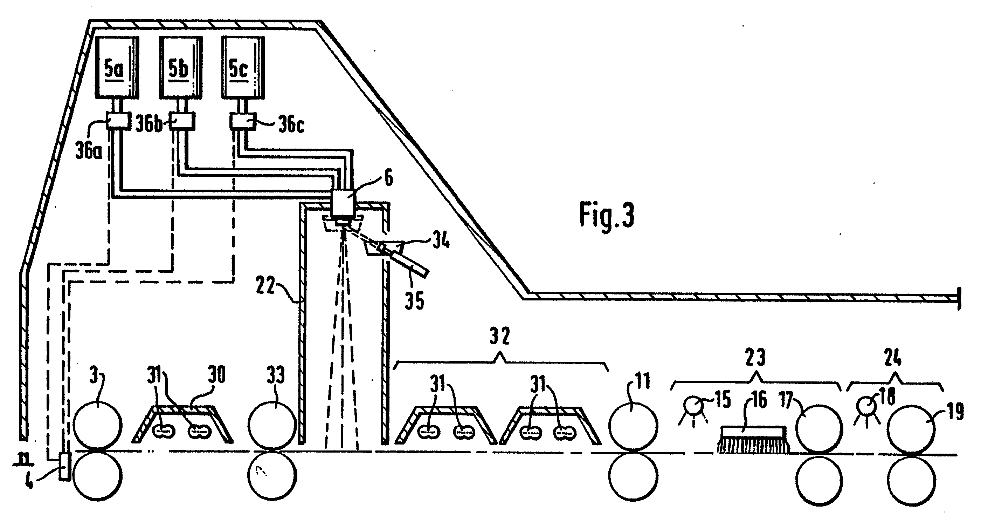

Bei der in Fig. 3 dargestellten Ausführungsform der Entschichtungsvorrichtung 21 ist ein einziger Sensor 4 vorgesehen, der vor dem ersten Transportwalzenpaar 3 angeordnet ist. Da die Druckplatten 1 mit vorgegebener Durchlaufgeschwindigkeit die Entschichtungsvorrichtung 21 durchlaufen, reicht es aus, wenn ein einziger Sensor 4 die Vorder- und die Hinterkante jeder Druckplatte 1 erfaßt und der Reihe nach die verschiedenen Stationen der Entschichtungsvorrichtung 21 mit entsprechender zeitlicher Verzögerung gegenüber dem jeweiligen Erfassungszeitpunkt der Vorder- und Hinterkante in Betrieb setzt und auch wieder abschaltet. Entsprechend dem zu entschichtenden Druckplattentyp wird vor dem Einlaufen der Druckplatte 1 derjenige Behälter der für den Plattentyp geeigneten Entschichterflüssigkeit angewählt. In der Leitung des einzelnen Behälters 5a bis 5c zu der bzw. zu den Breitstrahldüsen 6 befindet sich jeweils ein Einwegventil 36a, 36b bzw. 36c. Der Sensor 4 öffnet nach dem Erfassen der Vorderkante einer einlaufenden Druckplatte 1 mit entsprechender zeitlicher Verzögerung das Einwegventil in der Leitung des angewählten Behälters, um die Breitstrahldüsen 6 mit der Entschichterflüssigkeit zu beaufschlagen. Der Überdruck der Behälter 5a bis 5c beträgt wie bei den übrigen Ausführungsformen 1 bis 3 bar. Selbstverständlich ist es auch möglich, daß bei dieser Ausführungsform, ebenso wie bei den Ausführungsformen nach den Fig. 1 und 2, anstelle der drei Einwegventile ein einzelnes Mehrwegventil zum Einsatz kommt.

Gegenüber den Ausführungsformen nach den Fig. 1 und 2 weist die Ausführungsform nach Fig. 3 einen aufgeteilten Heizbereich auf, der aus einer Vorheizzone 30 vor dem und einer Hauptheizzone 32 nach dem Sprühbereich 22 besteht. In der Vorheizzone 30 wird die Druckplatte 1 auf eine Temperatur zwischen 20° und 30 °C und in der Hauptheizzone 32 anschließend auf eine Temperatur bis zu 55 °C aufgeheizt. Sowohl die Vorheiz- als auch die Hauptheizzone ist mit Zwillingsstrahlern 31 ausgerüstet, die gegenüber Einzelstrahlern die Druckplatte 1 schneller und gleichmäßiger aufheizen. Ein weiteres Transportwalzenpaar 33, das zwischen der Vorheizzone 30 und dem Sprühbereich 20 angeordnet ist, sorgt zusammen mit dem Abquetschwalzenpaar 11 am Ende der Hauptheizzone 32 für eine sichere Zwangsführung der durchlaufenden Druckplatte 1.

Im Sprühbereich 22 ist eine mit Reinigungsflüssigkeit, beispielsweise Wasser, gefüllte Reinigungswanne 34 vorgesehen, die innerhalb des Sprühbereichs 22 verschiebbar ist. Dazu ist die Reinigungswanne 34 mit einem Hubzylinder 35 verbunden, der die Reinigungswanne 34 entlang einer schrägen Linie anhebt bzw. absenkt. Die Reinigungswanne 34 wird von dem Hubzylinder 34 aus einer Stellung außerhalb des Flachstrahls der einzelnen oder von mehreren Breitstrahldüsen 6 in eine Stellung verfahren, in der die Düsenöffnung der Breitstrahldüsen 6 in die Reinigungsflüssigkeit in der Reinigungswanne 34 eintaucht. Dieser Reinigungsvorgang erfolgt jeweils vor dem Umschalten von einem der Behälter 5a bis 5c auf einen anderen dieser Behälter, sowie vor dem Ausschalten der Entschichtungsvorrichtung 21, um dem Verkleben der Öffnungen der Breitstrahldüsen 6 durch die Spülung entgegenzuwirken. Die Reinigungsstation 23 und die Gummierstation 24 dieser Ausführungsform sind identisch mit den entsprechenden Stationen in den Ausführungsformen nach den Fig. 1 und 2 und werden daher nicht mehr beschrieben.

## Patentansprüche

1. Entschichtungsvorrichtung für mit Flüssigtoner entwickelte vorbeschichtete Druckplatten, mit Transport-und Abquetschwalzenpaaren, zwischen denen die Druckplatten hindurchlaufen und mit einer Sprüheinrichtung zum Aufsprühen von Entschichterflüssigkeit auf die entwickelte Oberfläche der einzelnen Druckplatten, dadurch gekennzeichnet, daß mehrere Behälter (5a, 5b, 5c) mit unterschiedlichen Entschichterflüssigkeiten unter Druck gefüllt und jeder Behälter über ein Ventil (5; 36a, 36b, 36c) mit zumindest einer Breitstrahldüse (6) in einem Sprühbereich (22) verbunden sind, daß ein erster Sensor (4) die Öffnungszeiten der Ventile (5; 36a, 36b, 36c) entsprechend dem Format der durchlaufenden Druckplatte (1) steuert und daß dem Sprühbereich (22) eine Heizzone (9; 32) nachgeschaltet ist, in der der Entschichterflüssigkeitsfilm auf der Druckplatte (1) erwärmt wird.

2. Entschichtungsvorrichtung nach Anspruch 1, dadurch gekennzeichnet, daß unterhalb des Sprühbereichs (22) eine Wanne (7) zum Auffangen der seitlich über die Druckplatte (1) hinaus gesprühten Entschichterflüssigkeit angeordnet ist, die in einen an die Wanne angeschlossenen Auffangbehälter (8) abgeleitet wird.

3. Entschichtungsvorrichtung nach Anspruch 1, dadurch gekennzeichnet, daß das Mehrwegventil (5) mit einem Wasseranschluß (20) verbunden ist, der Wasser über das Mehrwegventil (5) an die Breitstrahldüse (6) zum Spülen der Düsenöffnungen liefert.

4. Entschichtungsvorrichtung nach Anspruch 1, dadurch gekennzeichnet, daß der erste Sensor (4) vor dem Transportwalzenpaar (3) an der Hinterkante eines Einlauftisches (2) für die Druckplatten (1) angeordnet ist, daß der erste Sensor (4) die Vorder- und die Hinterkante der einlaufenden Druckplatte erfaßt und jeweils ein Signal an das Mehrwegventil (5) liefert, um dieses mit zeitlicher Verzögerung zu öffnen bzw. sofort zu schließen.

5. Entschichtungsvorrichtung nach Anspruch 1, dadurch gekennzeichnet, daß die Entschichterflüssigkeit in den Behältern (5a, 5b, 5c) unter einem Druck zwischen 1 bis 3 bar steht.

6. Entschichtungsvorrichtung nach Anspruch 1, dadurch gekennzeichnet, daß in der Heizzone (9) der Entschichterflüssigkeitsfilm auf der Druckplatte (1) auf eine Temperatur zwischen 25° bis 55 °C erwärmt wird.

7. Entschichtungsvorrichtung nach Anspruch 1, dadurch gekennzeichnet, daß hinter der Heizzone (9) in Durchlaufrichtung das Abquetschwalzenpaar (11) und eine unter diesem befindliche Auffangwanne (12) angeordnet sind, daß ein Behälter (13) mit der Auffangwanne (12) verbunden ist und daß die von dem Abquetschwalzenpaar (11) von der Plattenoberfläche abgequetschten Schichtrückstände an lichtempfindlicher Schicht sowie an aufschwimmender Entschichterflüssigkeit in der Auffangwanne (12) aufgefangen und in den Behälter geleitet werden.

8. Entschichtungsvorrichtung nach Anspruch 7, dadurch gekennzeichnet, daß dem Abquetschwalzenpaar (11) ein zweiter Sensor (14) nachgeschaltet ist, der beim Erfassen der Vorderkante der durchlaufenden Druckplatte (1) eine Reinigungs- sowie eine Gummierstation (23 und 24) in Betrieb setzt.

9. Entschichtungsvorrichtung nach Anspruch 8, dadurch gekennzeichnet, daß die Reinigungsstation (23) eine Frischwasserspülung (15), eine Reinigungsbürste (16) und ein Quetschwalzenpaar (17) zum Reinigen, Neutralisieren und Abquetschen des Reinigungswassers von der Druckplattenoberfläche umfaßt und daß die Reinigungsstation (23) mit einer Abwasserleitung (26) ausgerüstet ist.

10. Entschichtungsvorrichtung nach Anspruch 8, dadurch gekennzeichnet, daß in der Gummierstation (24) die Gummierung über eine Sprühdüse (18) auf die Druckplattenoberfläche aufgetragen und die überschüssige Gummierung durch ein Walzenpaar (19) abgequetscht wird.

11. Entschichtungsvorrichtung nach Anspruch 1, dadurch gekennzeichnet, daß alle Behälter (5a, 5b, 5c) mit einem einzigen Mehrwegventil (5) verbunden sind.

12. Entschichtungsvorrichtung nach Anspruch 1, dadurch gekennzeichnet, daß jeder Behälter (5a, 5b, 5c) über ein Einwegventil (36a, 36b, 36c) mit zumindest einer Breitstrahldüse (6) in Verbindung steht.

13. Entschichtungsvorrichtung nach Anspruch 1, dadurch gekennzeichnet, daß ein einziger Sensor (4) die Breitstrahldüsen (6), die Reinigungs- und Gummierzone (23,24) sowie den übrigen Betriebsablauf der Entschichtungsvorrichtung (21) steuert.

14. Entschichtungsvorrichtung nach Anspruch 1, dadurch gekennzeichnet, daß eine Vorheizzone (30) vor dem und eine Hauptheizzone (32) nach dem Sprühbereich (22) angeordnet sind und daß in der Vorheizzone (30) die Druckplatten (1) auf 20° bis 30 °C und in der Hauptheizzone (32) auf eine Temperatur bis zu 55 °C aufgeheizt werden.

15. Entschichtungsvorrichtung nach Anspruch 14, dadurch gekennzeichnet, daß die Vorheiz- und die Hauptheizzone (30, 32) mit Zwillingsstrahlern (31) ausgerüstet sind.

16. Entschichtungsvorrichtung nach Anspruch 1, dadurch gekennzeichnet, daß eine mit Reinigungsflüssigkeit gefüllte Reinigungswanne (34) innerhalb des Sprühbereichs (22) beweglich angeordnet ist und daß die Reinigungswanne (34) von einem Hubzylinder (35) aus einer Stellung außerhalb des Flachstrahls der Breitstrahldüsen (6) in eine Stellung verfahrbar ist, in der die Düsenöffnung der Breitschlitzdüsen (6) in die Reinigungsflüssigkeit in der Reinigungswanne (34) eintaucht.

17. Entschichtungsvorrichtung nach Anspruch 16, dadurch gekennzeichnet, daß die Reinigungswanne (34) von dem Hubzylinder (35) entlang einer schrägen Linie anheb- und absenkbar ist.

18. Entschichtungsvorrichtung nach Anspruch 14, dadurch gekennzeichnet, daß vor und nach der Vorheizzone (30) je ein Transportwalzenpaar (3, 33) angeordnet ist.

## Claims

1. A decoating device for presensitized printing plates developed with liquid toner, having pairs of conveying and squeezing rollers between which the printing plates pass through and having a spray device for spraying decoating liquid onto the developed surface of the individual printing plates, wherein several containers (5a, 5b, 5c) are filled with different decoating liquids under pressure and each container is connected to at least one flat-jet nozzle (6) in a spraying section (22) via a valve (5; 36a, 36b, 36c), wherein a first sensor (4) controls the opening times of the valves (5: 36a, 36b, 36c) in accordance with the format of the printing plate (1) passing through and wherein the spraying section (22) is followed by a heating zone (9: 32) in which the decoating liquid film on the printing plate (1) is heated up.

2. The decoating device as claimed in claim 1, wherein there is provided under the spraying section (22) a trough (7) for collecting the decoating liquid sprayed laterally over the printing plate (1), which decoating liquid is conveyed to the collecting container (8) connected to the trough.

3. The decoating device as claimed in claim 1, wherein the multiway valve (5) is connected to a water connection (20) which supplies water via the multiway valve (5) to the flat-jet nozzle (6) for rinsing the jet orifices.

4. The decoating device as claimed in claim 1, wherein the first sensor (4) is provided in front of the pair (3) of conveying rollers at the rear edge of a loading table (2) for the printing plates (1), wherein the first sensor (4) registers the front edge and the rear edge of the incoming printing plate and in each case delivers a signal to the multiway valve (5) in order to open the latter with a time delay or to close it immediately.

5. The decoating device as claimed in claim 1, wherein the decoating liquid in the containers (5a, 5b, 5c) is under a pressure between 1 and 3 bar.

6. The decoating device as claimed in claim 1, wherein the film of decoating liquid on the printing plate (1) is heated to a temperature between 25° and 55°C in the heating zone (9).

7. The decoating device as claimed in claim 1, wherein the pair of squeezing rollers (11) and a collecting trough (12) situated underneath the latter are provided downstream of the heating zone (9) in the passing-through direction, wherein a container (13) is connected to the collecting trough (12) and wherein the layer residues of light-sensitive layer and also of floating decoating liquid squeezed off the plate surface by the pair (11) of squeezing rollers are collected in the collecting trough (12) and conveyed to the container (13).

8. The decoating device as claimed in claim 7, wherein the pair of squeezing rollers (11) is followed by a second sensor (14) which, on registering the front edge of the printing plate (1) passing through, sets a cleaning station and a gumming station (23 and 24) in operation.

9. The decoating device as claimed in claim 8, wherein the cleaning station (23) comprises a freshwater rinsing system (15), a cleaning brush (16) and a pair (17) of squeezing rollers for cleaning, neutralizing and squeezing the cleaning water off the printing plate surface and wherein the cleaning station (23) is equipped with a drainpipe (26).

10. The decoating device as claimed in claim 8, wherein the gumming solution is applied to the printing plate surface via a spraying nozzle (18) in the gumming station (24) and the excess gumming solution is squeezed off by a roller pair (19).

11. The decoating device as claimed in claim 1, wherein all the containers (5a, 5b, 5c) are connected to a single multiway valve (5).

12. The decoating device as claimed in claim 1, wherein each container (5a, 5b, 5c) is connected to at least one flat-jet nozzle (6) via a one-way valve (36a, 36b, 36c).

13. The decoating device as claimed in claim 1, wherein a single sensor (4) controls the flat-jet nozzles (6), the cleaning and gumming zone (23, 24) and also the remaining schedule of operations of the decoating device (21).

14. The decoating device as claimed in claim 1, wherein a preheating zone (39) is provided ahead of the spraying section (22) and a main heating zone (32) is provided after the spraying section (22) and wherein the prinitng plates (1) are heated in the preheating zone (30) to 20° to 30°C and in the main heating zone (32) to a temperature of up to 55°C.

15. The decoating device as claimed in claim 14, wherein the preheating zone and the main heating zone (30, 32) are equipped with twin radiators (31).

16. The decoating device as claimed in claim 1, wherein a cleaning trough (34), filled with cleaning liquid, is movably provided within the spraying section (22) and wherein the cleaning trough (34) can be moved by a hydraulic jack (35) from a position outside the flat jet of the flat-jet nozzles (6) to a position in which the nozzle orifice of the flat-jet nozzles (6) is emersed in the cleaning liquid in the cleaning trough (34).

17. The decoating device as claimed in claim 16, wherein the cleaning trough (34) can be raised and lowered by the hydraulic jack (35) along an inclined line.

18. The decoating device as claimed in claim 14, wherein one pair (3, 33) each of conveying rollers is provided in front of and after the preheating zone (30).

## Revendications

1. Appareil de dépouillement, pour plaques d'impression presensibilisées déjà développées à l'aide d'un toner liquide, du type comprenant des paires de rouleaux, de transport et d'élimination par serrage, entre lesquels passent les plaques d'impression, et un dispositif permettant de pulvériser un agent liquide de dépouillement sur la surface développée des différentes plaques d'impression, caractérisé en ce que plusieurs réservoirs (5a, 5b, 5c) sont remplis sous pression d'agents liquides de dépouillement qui sont différents, chaque réservoir étant relié par l'intermédiaire d'une vanne (5; 36a, 36b, 36c) à au moins une buse de pulvérisation à jet plan (6) se trouvant dans une zone de pulvérisation (22), en ce qu'un premier détecteur (4) commande les temps d'ouverture des vannes (5; 36a, 36b, 36c) en fonction du format de la plaque d'impression (1) traversant l'appareil et en ce qu'il est disposé, en aval de la zone de pulvérisation (22), une zone de chauffage (9; 32) dans laquelle le film d'agent liquide de dépouillement fait l'objet d'un chauffage en même temps que la plaque d'impression (1).

2. Appareil de dépouillement suivant la revendication 1, caractérisé en ce qu'il est disposé, au-dessous de la zone de pulvérisation (22), une cuve (7) servant à recueillir l'agent liquide de dépouillement qui est pulvérisé au-delà des côtés de la plaque d'impression (1), cet agent liquide de dépouillement étant évacué dans un réservoir collecteur (8) relié à la cuve.

3. Appareil de dépouillement suivant la revendication 1, caractérisé en ce que la vanne à plusieurs voies (5) est reliée à une prise d'eau (20) qui, par l'intermédiaire de cette vanne à plusieurs voies (5), envoie de l'eau à la buse de pulvérisation à jet plan (6) en vue de rincer les orifices de cette buse.

4. Appareil de dépouillement suivant la revendication 1, caractérisé en ce que le premier détecteur (4) est disposé en amont de la paire de rouleaux de transport (3) et à l'endroit du bord arrière d'une table d'entrée (2) prévue pour les plaques d'impression (1) et en ce que le premier détecteur (4) relève la présence du bord avant et du bord arrière de la plaque d'impression entrante et envoie à chaque fois un signal à la vanne à plusieurs voies (5) afin d'ouvrir celle-ci avec un certain retard ou de la fermer immédiatement.

5. Appareil de dépouillement suivant la revendication 1, caractérisé en ce que l'agent liquide de dépouillement contenu dans les réservoirs (5a, 5b, 5c) est sous une pression comprise entre 1 et 3 bars.

6. Appareil de dépouillement suivant la revendication 1, caractérisé en ce que, dans la zone de chauffage (9), le film d'agent liquide de dépouillement situé sur la plaque d'impression (1) est porté à une température comprise entre 25 et 55°C.

7. Appareil de dépouillement suivant la revendication 1, caractérisé en ce que c'est en aval de la zone de chauffage (9) suivant la direction de déplacement que sont disposées la paire de rouleaux d'élimination par serrage (11) et une cuve collectrice (12) située au-dessous de celle-ci, en ce qu'un réservoir (13) est relié à cette cuve collectrice (12) et en ce que les résidus de la couche photosensible, ainsi que l'agent liquide de dépouillement restant en surface, qui sont éliminés de la surface de la plaque par la paire de rouleaux de serrage (11) sont recueillis dans la cuve collectrice (12) et envoyés dans le réservoir.

8. Appareil de dépouillement suivant la revendication 7, caractérisé en ce qu'il est prévu, disposé en aval de la paire de rouleaux d'élimination par serrage (11), un deuxième détecteur (14) qui, lorsqu'il détecte le bord avant de la plaque d'impression (1) traversant l'appareil, met en service un poste de nettoyage (23) et un poste de vernissage (24).

9. Appareil de dépouillement suivant la revendication 8, caractérisé en ce que le poste de nettoyage (23) comprend une pulvérisation d'eau fraîche (15), une brosse de nettoyage (16) et une paire de rouleaux de serrage (17) servant à nettoyer et neutraliser la surface de la plaque d'impression et à en éliminer, par serrage, l'eau de nettoyage et en ce que le poste de nettoyage (23) est pourvu d'une tuyauterie d'eaux usées (26).

10. Appareil de dépouillement suivant la revendication 8, caractérisé en ce qu'au poste de vernissage (24), le vernis est appliqué sur la surface de la plaque d'impression à l'aide d'une buse de pulvérisation (18) et l'excès de vernis est éliminé par serrage à l'aide d'une paire de rouleaux (19).

11. Appareil de dépouillement suivant la revendication 1, caractérisé en ce que tous les réservoirs (5a, 5b, 5c) sont reliés à une vanne à plusieurs voies (5) unique.

12. Appareil de dépouillement suivant la revendication 1, caractérisé en ce que chaque réservoir (5a, 5b, 5c) communique avec au moins une buse de pulvérisation à jet plan (6) par l'intermédiaire d'une vanne à passage direct (36a, 36b, 36c).

13. Appareil de dépouillement suivant la revendication 1, caractérisé en ce qu'un détecteur (4) unique commande les buses de pulvérisation à jet plan (6), les zones de nettoyage et de vernissage (23, 24), ainsi que le reste du déroulement du fonctionnement de l'appareil de dépouillement (21).

14. Appareil de dépouillement suivant la revendication 1, caractérisé en ce qu'il est prévu une zone de préchauffage (30) en amont de la zone de pulvérisation (22) et une zone de chauffage principal (32) en aval de celle-ci, et en ce que, dans la zone de préchauffage (30), les plaques d'impression (1) sont portées à 20 à 30°C et, dans la zone de chauffage principal (32), à une température allant jusqu'à 55°C.

15. Appareil de dépouillement suivant la revendication 14, caractérisé en ce que les zones de préchauffage et de chauffage principal (30, 32) sont équipées de lampes radiantes doubles (31).

16. Appareil de dépouillement suivant la revendication 1, caractérisé en ce qu'une cuve de nettoyage (34), remplie de liquide de nettoyage, est disposée de manière mobile à l'intérieur de la zone de pulvérisation (22) et en ce que, à partir d'une position située à l'extérieur du jet plan des buses de pulvérisation (6), cette cuve de nettoyage (34) peut être déplacée par un vérin (35) jusque dans une position dans laquelle les orifices des buses à jet plan (6) sont immergées dans le liquide de nettoyage contenu dans cette cuve de nettoyage (34).

17. Appareil de dépouillement suivant la revendication 16, caractérisé en ce que la cuve de nettoyage (34) peut être soulevée et abaissée par le vérin (35) le long d'une ligne inclinée.

18. Appareil de dépouillement suivant la revendication 14, caractérisé en ce que des paires de rouleaux de transport (3, 33) sont disposées l'une en amont et l'autre en aval de la zone de préchauffage (30).

Fig.1

Fig.2

EP 0 223 154 B1

Fig.3

EP 0 223 154 B1